(19) Europäisches Patentamt
European Patent Office
Office européen des brevets

(11) **EP 3 039 786 B1**

(12) **EUROPÄISCHE PATENTSCHRIFT**

(45) Veröffentlichungstag und Bekanntmachung des Hinweises auf die Patenterteilung:
**11.09.2019 Patentblatt 2019/37**

(21) Anmeldenummer: **14739753.3**

(22) Anmeldetag: **09.07.2014**

(51) Int Cl.:
***H03K 5/156*** *(2006.01)*

(86) Internationale Anmeldenummer:
**PCT/EP2014/064677**

(87) Internationale Veröffentlichungsnummer:
**WO 2015/028186 (05.03.2015 Gazette 2015/09)**

(54) **SCHALTUNG UND VERFAHREN ZUR ERZEUGUNG EINES AUSGANGSSIGNALS MIT EINEM VARIABLEN TASTVERHÄLTNIS**

CIRCUIT AND METHOD FOR PRODUCING AN OUTPUT SIGNAL WITH A VARIABLE DUTY RATIO

CIRCUIT ET PROCÉDÉ DE GÉNÉRATION D'UN SIGNAL DE SORTIE À RAPPORT CYCLIQUE VARIABLE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **30.08.2013 DE 102013217365**

(43) Veröffentlichungstag der Anmeldung:
**06.07.2016 Patentblatt 2016/27**

(73) Patentinhaber: **Robert Bosch GmbH**
**70442 Stuttgart (DE)**

(72) Erfinder: **HERMANN, Carsten**
**72762 Reutlingen (DE)**

(56) Entgegenhaltungen:
**EP-A1- 0 135 121      US-A- 3 883 756**
**US-A- 5 451 893      US-A- 6 154 076**

**Beschreibung**

Die vorliegende Erfindung betrifft eine Schaltung und ein Verfahren zur Erzeugung eines Ausgangssignals mit einem variablen Tastverhältnis. Weiterhin betrifft die Erfindung einen digitalen Schaltregler sowie ein Kraftfahrzeug mit einer derartigen Schaltung beziehungsweise einem derartigen digitalen Schaltregler.

Stand der Technik

Signale, wie zum Beispiel Taktsignale oder PWM (pulsweitenmodulierte) Signale, weisen ein Tastverhältnis, das auch Tastgrad genannt wird, auf. Das Tastverhältnis definiert das Verhältnis von Impulsdauer, das heißt aktivem Signalteil, zu der Periodendauer des Signals.

Taktsignale mit einem Tastverhältnis von 50% oder Taktsignale, die zum Beispiel durch bistabile Kippstufen wie Flipflops aus einem Grundtakt erzeugt werden, sind in der Digitaltechnik einfach zu realisieren. So kann zum Beispiel aus einem Grundtakt ein Taktsignal mit halber Frequenz und einem Tastverhältnis von 25% oder 75% abgeleitet werden. Je dichter das Tastverhältnis an der 0% beziehungsweise 100% Grenze liegt, desto höher muss der Grundtakt sein. Es sind zudem nur diskrete Werte für das Tastverhältnis einstellbar.

Oftmals wird jedoch ein Takt benötigt, dessen Tastverhältnis einen beliebigen Wert annehmen kann. Erschwerend steht oft genug ein entsprechend hoher Grundtakt nicht zur Verfügung.

Ein wichtiger Anwendungsfall für derartige Takte oder Taktsignale ist ein digitaler Schaltregler, bei dem heute die prinzipielle Schwierigkeit besteht, das vom Digitalteil errechnete Tastverhältnis in ein analoges Signal zur Ansteuerung einer Endstufe des Schaltreglers umzusetzen. Üblich sind dazu entweder die Verwendung eines sehr viel schnelleren Grundtaktes für den Digitalteil oder eine Verschiebung von Funktionen, die digital gelöst werden können, in den Analogteil.

Bei einem schnelleren Grundtakt werden hohe Anforderungen an den Digitalteil gestellt. Soll zum Beispiel eine Schaltreglerfrequenz von 1 MHz mit einem auf circa. 1% genau einstellbarem Tastverhältnis realisiert werden, so bräuchte man einen digitalen Takt von 1 MHz x $2^7$ = 128 MHz, was beispielsweise im Automotive-Bereich derzeit kaum zu realisieren ist.

Bei einer Verschiebung in den Analogteil entsteht ein hoher Aufwand bei der Signalumwandlung, zum Beispiel in Form eines schnellen D/A Wandlers sowie einem Komparator und Sägezahngenerator mit genauer Amplitude.

Aus US 6 154 076 A, US 3 883 756 A, EP 0 135 121 A1 und US 5 451 893 A sind Schaltungen und Verfahren der eingangs genannten Art bekannt.

Offenbarung der Erfindung

Erfindungsgemäß wird eine Schaltung zur Erzeugung eines Ausgangssignals mit einem zweiten Tastverhältnis aus einem Eingangssignal mit einem ersten Tastverhältnis zur Verfügung gestellt, welche einen ersten Kondensator und einen zweiten Kondensator aufweist, die jeweils mit mindestens einer Ladungsquelle zum periodischen Laden der Kondensatoren verbunden sind, wobei der erste Kondensator über einen von dem Eingangssignal gesteuerten ersten Schalter und der zweite Kondensator über einen von dem invertierten Eingangssignal gesteuerten zweiten Schalter geladen wird, wobei eine Spannung über den geladenen ersten Kondensator als Referenzspannung definiert ist und wobei das Tastverhältnis des Ausgangssignals von der Ladezeitdauer des zweiten Kondensators bis zum Erreichen der Referenzspannung definiert ist, wobei ein Komparator zum Vergleich der Referenzspannung und der Spannung des zweiten Kondensators vorgesehen ist und wobei ein bistabiles Kippglied vorgesehen ist, dessen Eingänge mit einem Ausgang des Komparators und mit dem Eingangssignal in Kommunikation stehen und mit dessen Ausgang das Ausgangssignal zur Verfügung gestellt ist, sodass die Impulsdauer des Ausgangssignals der Ladezeitdauer des ersten Kondensators plus der Ladezeitdauer des zweiten Kondensators entspricht.

Die erfindungsgemäße Schaltung hat den Vorteil, dass mit einer einfachen Schaltung ein beliebiges und präzises Tastverhältnis erzeugt wird. Dies ist sogar möglich mit einem geringen Grundtakt, das heißt mit einem Eingangssignal oder Eingangs-Taktsignal, dessen Frequenz oder Takt im Bereich des Takts beziehungsweise identisch zu dem Takt des Ausgangssignals oder Ausgangs-Taktsignal ist. Das Zusammenwirken zwischen dem ersten Kondensator, der in geladenem Zustand eine Referenzspannung vorgibt, und dem zweiten Kondensator, dessen Ladezeitdauer bis zum Erreichen der über diesem Kondensator abfallenden Referenzspannung das Tastverhältnis vorgibt, ist schaltungstechnisch einfach zu realisieren.

Der Begriff Ladungsquelle umfasst hier eine Quelle, wie eine Stromquelle, Konstantstromquelle oder Spannungsquelle gegebenenfalls mit zusätzlicher Beschaltung, die geeignet ist, einen Kondensator in endlicher Zeit aufzuladen.

Ein Komparator ist zum Vergleich der Referenzspannung und der Spannung des zweiten Kondensators vorgesehen und ein bistabiles Kippglied ist vorgesehen, dessen Eingänge mit einem Ausgang des Komparators und mit dem Eingangssignal in Kommunikation stehen und mit dessen Ausgang das Ausgangssignal zur Verfügung gestellt ist.

Dieser einfache Aufbau ermöglicht eine schnelle und präzise Erzeugung des Ausgangssignals. Es kann vorgesehen sein, dass der Komparator ein Signal ausgibt, wenn die beiden Spannungen über die Kondensatoren den gleichen Wert haben, ein Vergleich mit einem Offset ist ebenso möglich. Das Ausgangssignal kann direkt an dem bistabilen Kippglied oder Flipflop anliegen oder über eine weitere Beschaltung zur Verfügung gestellt werden.

Es ist möglich, dass das Eingangssignal und das Ausgangssignal eine identische Frequenz beziehungsweise Takt aufweisen. Die Erzeugung des Ausgangssignals aus einem Grundtakt mit gleicher Frequenz wird durch die Verwendung beziehungsweise Beschaltung von zwei Kondensatoren möglich und erlaubt einen breiten Einsatz der Schaltung. Das Eingangs- und Ausgangssignal können - bei gleichem Takt oder Frequenz - zeitversetzt sein.

Die Impulsdauer kann gleich der Ladezeit des zweiten Kondensators plus der halben Periodendauer des Eingangssignals sein.

An einem Signaleingang des bistabilen Kippglieds kann der Impulsanteil des Eingangssignals und an einem Reset-Eingang des bistabilen Kippglieds kann das Ausgangssignal des Komparators derart anliegen, dass das Tastverhältnis des Ausgangssignals zwischen 50% und 100% beträgt. Mit einer einfachen Beschaltung des bistabilen Kippglieds kann ein Tastverhältnis zwischen 50% und 100% eingestellt werden. Es wird das Tastverhältnis des Eingangssignals um die Ladezeitdauer des zweiten Kondensators verlängert.

Das erfindungsgemäße Verfahren zur Erzeugung eines Ausgangssignals mit einem zweiten Tastverhältnis aus einem Eingangssignal mit einem ersten Tastverhältnis umfasst grundsätzlich folgende Schritte: dass ein erster Kondensator periodisch von einer Ladungsquelle bis zu einer Referenzspannung aufgeladen wird, dass ein zweiter Kondensator periodisch von einer weiteren Ladungsquelle aufgeladen wird, wobei der erste Kondensator über einen von dem Eingangssignal gesteuerten ersten Schalter und der zweite Kondensator über einen von dem invertierten Eingangssignal gesteuerten zweiten Schalter geladen wird, und dass das Tastverhältnis des Ausgangssignals aus der bis zum Erreichen der Referenzspannung benötigten Ladezeitdauer des zweiten Kondensators gebildet wird, wobei ein Komparator die Referenzspannung und die Spannung des zweiten Kondensators vergleicht und wobei ein bistabiles Kippglied vorgesehen ist, dessen Eingänge mit einem Ausgang des Komparators und mit dem Eingangssignal in Kommunikation stehen und mit dessen Ausgang das Ausgangssignal zur Verfügung gestellt wird, sodass die Impulsdauer des Ausgangssignals der Ladezeitdauer des ersten Kondensators plus der Ladezeitdauer des zweiten Kondensators entspricht. Das periodische Laden bereitet den Takt des Ausgangssignals vor, wobei der Takt exakt von der Ladezeitdauer des ersten Kondensators abhängen kann, das heißt von der Zeit, in welcher der entladene oder definiert teilentladene Kondensator vollständig geladen ist. Die Ladezeitdauer kann dabei dem Takt direkt entsprechen oder ein Teil oder Vielfaches des Taktes betragen.

Vorteilhafterweise ist vorgesehen, dass parallel zwei (Zwischen-) Ausgangssignale erzeugt werden und dass die beiden Ausgangssignale und das Eingangssignal zur Erzeugung des (endgültigen) Ausgangssignals XOR-verknüpft werden. Dieses Verfahren beziehungsweise diese Schaltung ermöglicht eine Frequenzverdopplung mittels einer einfachen kombinatorischen Logik. Vorzugsweise haben die beiden (Zwischen-) Ausgangssignale zu dem Tastverhältnis von 50% komplementäre Tastverhältnisse, zum Beispiel von 25% und 75%.

Gemäß einem Aspekt der Erfindung ist ein digitaler Schaltregler vorgesehen, mit einem Digitalteil zum Erzeugen eines Ansteuerungssignals mit einem Tastverhältnis, einer mit dem Ansteuerungssignal angesteuerten Endstufe und einer Schaltung wie zuvor beschrieben zur Erzeugung des Ansteuerungssignals. Es gelten die zuvor beschriebenen Vorteile und Modifikationen. Der Digitalteil berechnet das Tastverhältnis, mit dem die Endstufe takten soll. Die digitale Tastverhältnisinformation wird von der erfindungsgemäßen Schaltung in ein Ansteuerungssignal in Form eines analogen PWM-Signals umgewandelt, welches die Endstufe ansteuert. Weitere Komponenten des digitalen Schaltreglers, wie die Erfassung der Regelspannung und eventuell der Eingangsspannung, werden hier nicht betrachtet. Erfindungsgemäß wird für die Umsetzung in das Ansteuerungssignal nur ein geringer Takt für den Digitalteil benötigt.

Gemäß einem weiteren Aspekt der Erfindung ist ein Kraftfahrzeug mit einem digitalen Schaltregler wie zuvor beschrieben vorgesehen, wobei der Schaltregler mit einem Bordnetz des Kraftfahrzeugs in Verbindung steht. Für die besonderen Anforderungen im Kraftfahrzeugbereich ist der erfindungsgemäße Schaltregler besonders geeignet. Es gelten die zuvor beschriebenen Vorteile und Modifikationen.

Gemäß noch einem weiteren Aspekt der Erfindung ist ein Kraftfahrzeug mit einer Schaltung wie zuvor beschrieben vorgesehen, wobei die Schaltung mit einem Bordnetz des Kraftfahrzeugs in Verbindung steht. Für die besonderen Anforderungen im Kraftfahrzeugbereich ist die erfindungsgemäße Schaltung besonders geeignet. Es gelten die zuvor beschriebenen Vorteile und Modifikationen.

Die Erfindung ist im Kraftfahrzeugbereich besonders vorteilhaft, da hier die Halbleitertechnologien zum Beispiel im Vergleich zu denen der Unterhaltungselektronik etwa zehn Jahre zurück sind. Entsprechend sind hier Takte im Bereich von 100 MHz bereits eine sehr große Herausforderung.

Vorteilhafte Weiterbildungen der Erfindung sind in den Unteransprüchen angegeben und in der Beschreibung beschrieben.

Zeichnungen

Ausführungsbeispiele der Erfindung werden anhand der Zeichnungen und der nachfolgenden Beschreibung näher erläutert. Es zeigen:

Figur 1 ein Schaltbild einer Schaltung für ein festes Tastverhältnis zwischen 0% und 100%,

Figur 2 ein Schaltbild der Ansteuerschaltung aus Figur 1,

Figur 3 ein Diagramm mit Signalverläufen der Schaltung aus Figur 1,

Figur 4 ein Schaltbild einer Schaltung für ein festes Tastverhältnis zwischen 50% und 100%,

Figur 5 ein Diagramm mit Signalverläufen der Schaltung aus Figur 4,

Figur 6 ein Schaltbild einer Schaltung für ein festes Tastverhältnis zwischen 0% und 50%,

Figur 7 ein Diagramm mit Signalverläufen der Schaltung aus Figur 6,

Figur 8 ein Schaltbild einer Schaltung für ein variables Tastverhältnis zwischen 0% und 100%,

Figur 9 ein Schaltbild einer Schaltung zum Erzeugen eines Signals mit doppelter Frequenz, und

Figur 10 eine schematische Darstellung eines digitalen Schaltreglers. Ausführungsformen der Erfindung

Im Folgenden werden Schaltungen beschrieben, die aus einem vorgegebenen Grundtakt mit einem Tastverhältnis von 50 % einen Takt mit gleicher Frequenz und einem beliebigen und präzisen Tastverhältnis zwischen 0 % und 100 % generieren. Das beliebige Tastverhältnis kann entweder fest oder variabel eingestellt werden. Das variable Tastverhältnis kann beispielsweise über ein Datenwort individuell eingestellt werden.

Die Schaltungen weisen das Grundprinzip auf, dass zwei Kondensatoren zyklisch von jeweils einer Ladungsquelle, zum Beispiel in Form einer Stromquelle, geladen werden. Aus dem Verhältnis der Kondensatoren, das heißt insbesondere deren Kapazitäten, und dem Verhältnis der Ströme ergeben sich unterschiedliche Ladezeiten, um beide Kondensatoren auf eine definierte Spannung, welche identisch sein kann, aufzuladen. Die unterschiedlichen Ladezeiten können dann verwendet werden, um ein Taktsignal mit einem beliebigen und präzisen Tastverhältnis zu generieren, indem eine der beiden Zeiten als Referenz verwendet wird, während die andere direkt als Einstellparameter für das Tastverhältnis dient. Die Referenz des einen Kondensators kann zum Beispiel die Ladezeit oder dessen Spannung sein, welche dann als Referenz- oder Vergleichswert für den zweiten Kondensator dient.

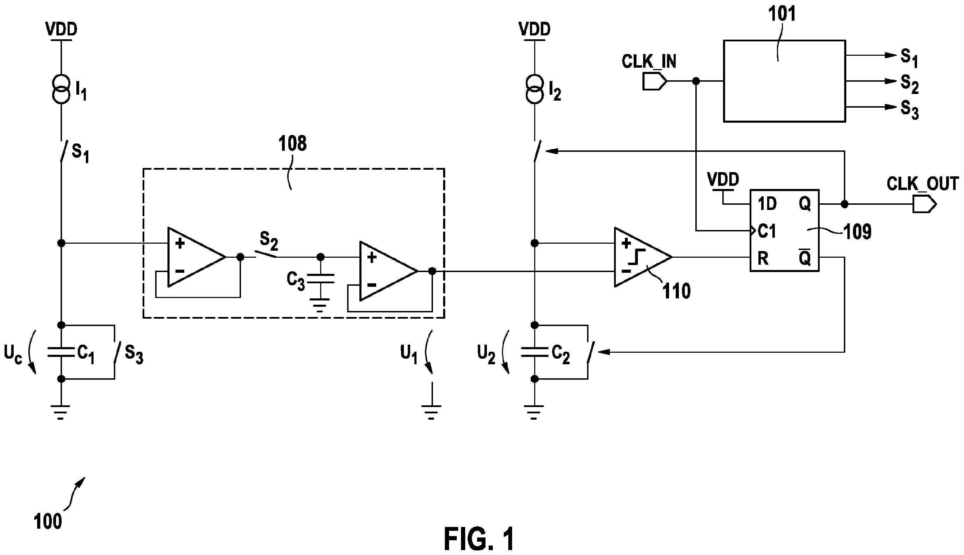

In der Figur 1 ist eine Schaltung 100 zur Erzeugung eines beliebigen Tastverhältnisses zwischen 0 % und 100 % dargestellt. Das Tastverhältnis kann 0% betragen, das heißt, es ist dann kein Impulsanteil im Ausgangssignal enthalten. Ebenso kann das Tastverhältnis TV 100% betragen, das heißt, das Ausgangssignal besteht nur aus einem Impulsanteil. Der Ausdruck zwischen 0% und 100% kann auch als 0% < TV < 100% definiert sein. Die obige Erläuterung, dass die Grenzen des Tastverhältnisses inkludiert oder exkludiert sein können, gilt auch für weitere hier genannte Bereiche.

Ein Eingangstakt CLK_IN mit einem ersten Tastverhältnis wird der Schaltung 100 zugeführt, welche daraus ein Ausgangssignal CLK_OUT mit einem zweiten Tastverhältnis erzeugt. In der Regel ist das erste Tastverhältnis unterschiedlich zu dem zweiten Tastverhältnis.

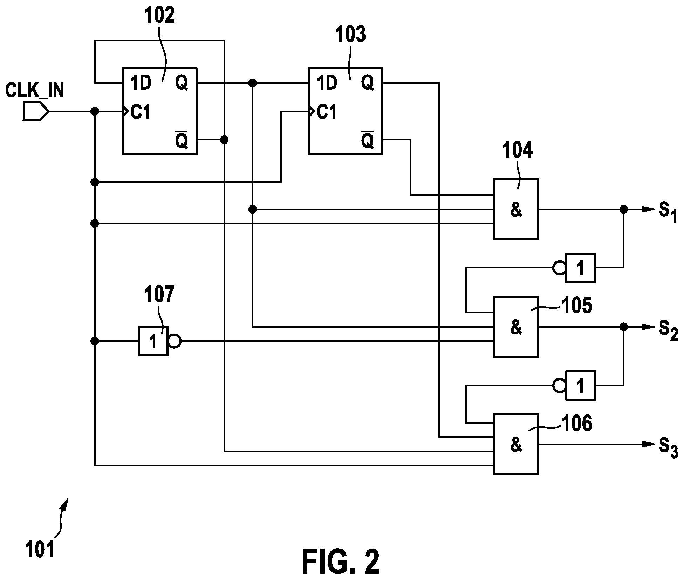

Die Schaltung 100 weist einen ersten Kondensator $C_1$ auf, der über einen Schalter $S_1$ mit einer ersten Ladungsquelle $I_1$ verbunden ist. Die Ladungsquelle, hier in Form einer Stromquelle, stellt periodisch einen Strom $I_1$ an den Kondensator $C_1$ zur Verfügung. Die Periodizität des Ladens des ersten Kondensators $C_1$ wird über das Öffnen beziehungsweise Schließen des Schalters $S_1$ realisiert. Dazu erzeugt eine Schalteransteuerung 101 aus dem Grundtakt CLK_IN drei nicht überlappende Taktsignale $S_1$, $S_2$ und $S_3$. Die Schalteransteuerung 101 ist in Figur 2 detailliert dargestellt.

Figur 2 zeigt das Schaltungsdiagramm der Schalteransteuerung 101. Das Eingangssignal beziehungsweise der Grundtakt CLK_IN liegen an Takteingängen von zwei D-Flipflops 102 und 103 an, sodass mit jeder steigenden Flanke von CLK_IN die D-Flipflops 102 und 103 gesetzt werden können. Weiterhin liegt das Eingangssignal CLK_IN an drei UND-Gattern 104, 105 und 106 an, wobei der Grundtakt CLK_IN über einen Inverter 107 invertiert an dem UND-Gatter 105 anliegt.

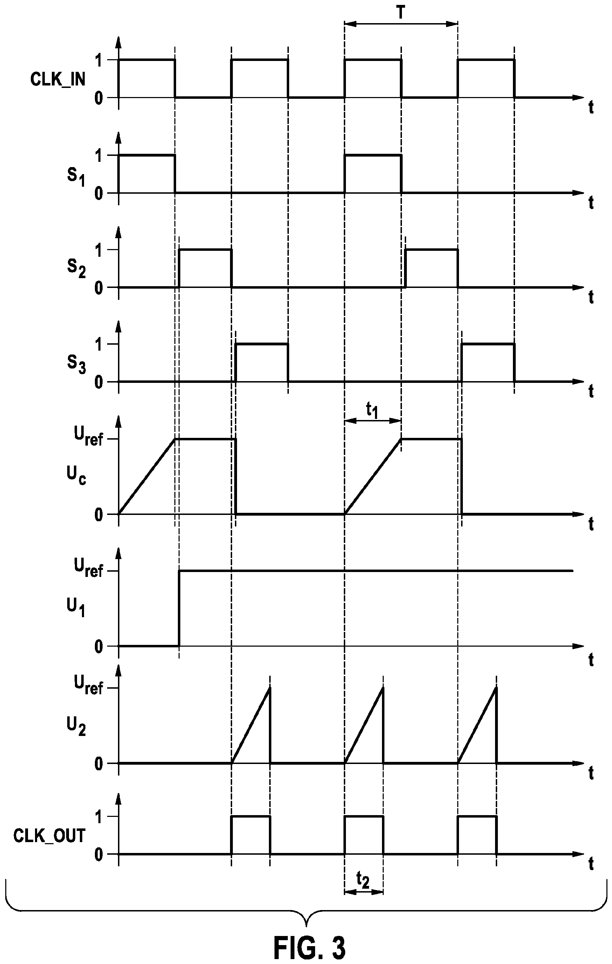

Mit der ersten steigenden Taktflanke von CLK_IN wird das D-Flipflop 102 gesetzt, sodass Q=1 wird. Das D-Flipflop 103 ist noch nicht gesetzt, sodass dessen invertierter Ausgang gleich 1 ist. Entsprechend schaltet das UND-Gatter 104 und stellt den ersten Impuls des Eingangssignals CLK_IN durch (siehe Figur 3). Mit fallender Flanke von CLK_IN sperrt das UND-Gatter 104, sodass das Schaltersignal $S_1$ dem ersten Impuls des Grundtaktes CLK_IN entspricht.

Das UND-Gatter 105, an dessen Ausgang das Schaltersignal $S_2$ anliegt, schaltet aufgrund des Inverters 107 während des Nullpegels des Grundtaktes CLK_IN. Da in dem Inverter 105 das invertierte Schaltersignal $S_1$ anliegt, steigt das Schaltersignal $S_2$ etwas zeitverzögert im Vergleich zu $S_1$ an, sodass die beiden Signale überlappungsfrei sind.

Mit der nächsten positiven Flanke von CLK_IN werden die Zustände der beiden D-Flipflops 102 und 103 weitergeschoben. Dies bedeutet, dass an dem invertierten Ausgang des Flipflops 102 und an dem nicht invertierten Ausgang des Flipflops 103 eine 1 anliegt, sodass nun das UND-Gatter 106 den Impuls des Grundtaktes CLK_IN als Signal $S_3$ ausgibt. Wie auch bei dem Signal $S_2$ wird hier bei dem Signal $S_3$ durch die invertierte Berücksichtigung des Signals $S_2$ die Nichtüberlappung sichergestellt. Da der nicht invertierende Ausgang des D-Flipflops 102 Null ist, schaltet das UND-Gatter 105 bei der zweiten fallenden Flanke von CLK_IN nicht. Bei der nächsten steigenden Flanke des Eingangssignals CLK_IN wiederholt sich das beschriebene und in Figur 3 dargestellte Verfahren.

Im Folgenden wird nun die Funktionsweise der Schaltung 100 aus Figur 1 beschrieben. In Figur 3 sind die Signalverläufe der Schaltung 100 aus Figur 1 dargestellt. Während $S_1 = 1$, das heißt bei geschlossenem Schalter $S_1$, wird die Kapazität $C_1$ von der Stromquelle $I_1$ auf die Spannung $U_{ref}$ aufgeladen. Oder anders ausgedrückt, wird der Kondensator $C_1$ von der Stromquelle $I_1$ geladen, bis die Spannung $U_c$ über dem Kondensator den Wert $U_{ref}$ erreicht hat. Die Spannung $U_{ref}$ berechnet sich zu:

$$(1) \qquad U_{ref} = I_1 / (t_1 \times C_1)$$

wobei die Ladezeit $t_1$ der halben Periodendauer T des Grundtaktes CLK_IN entspricht:

$$(2) \qquad t_1 = C_1 \times U_{ref} / I_1 = T / 2.$$

Die Spannung $U_{ref}$ wird von einer Abtast-Halte-Schaltung 108, auch Sample-and-hold-Schaltung genannt, während $S_2 = 1$ auf die Kapazität $C_3$ übertragen und dort gespeichert. Die Spannung $U_{ref}$ steht als Spannung $U_1$ mit $S_2 = 1$ am Ausgang der Abtast-Halte-Schaltung 108 zur Verfügung.

Während $S_3 = 1$ wird der Kondensator $C_1$ wieder entladen. Das Auf- und Entladen von $C_1$ setzt sich durch den Verlauf der Signale $S_1$, $S_2$ und $S_3$ periodisch fort. Die Spannung $U_1$ am Ausgang der Abtast-Halte-Schaltung 108 ändert sich nach der ersten Periode von CLK_IN nur noch, wenn sich die Periodendauer T des Grundtaktes CLK_IN oder der Strom $I_1$ ändern sollten.

Mit jeder steigenden Flanke des Eingangssignals CLK_IN wird das D-Flipflop 109 gesetzt, was dazu führt, dass das Ausgangssignal CLK_OUT = 1 gesetzt wird und die Kapazität $C_2$ von der Stromquelle $I_2$ geladen wird, bis die Spannung $U_2$ über den Kondensator $C_2$ den Wert $U_{ref}$ erreicht. Wenn $U_2 = U_{ref}$ setzt ein Komparator 110, der die beiden Spannungen $U_1$ und $U_2$ miteinander vergleicht, das D-Flipflop 109 zurück. Durch das Zurücksetzen des D-Flipflops 109 geht CLK_OUT auf Null, sodass der Impuls des Ausgangssignals CLK_OUT beendet wird. Mit dem Zurücksetzen des D-Flipflops 109 wird über den invertierenden Ausgang mittels eines Schalters der Kondensator $C_2$ entladen.

Der Takt des Ausgangssignals CLK_OUT wird über die Ladezeit $t_1$ des ersten Kondensators $C_1$ bestimmt. Die Impulsdauer und damit das Tastverhältnis des Ausgangssignals CLK_OUT wird von der Ladezeitdauer $t_2$ des zweiten Kondensators bestimmt. Die Spannung $U_c$ des ersten geladenen Kondensators $C_1$ in Höhe von $U_{ref}$ dient als Referenzspannung für den zweiten Kondensator $C_2$. Genauer gesagt, wird der Impuls des Ausgangssignals CLK_OUT beendet, wenn die Spannung $U_2$ über dem zweiten Kondensator $C_2$ den Wert $U_{ref}$ erreicht. Die Frequenz oder der Takt der Ausgangssignals CLK_OUT kann auch von der Frequenz des Eingangssignals CLK_IN bestimmt werden. Die Frequenz des Eingangssignals kann gleich oder ein Vielfaches der Frequenz des Ausgangssignals betragen. Hier entspricht die Frequenz des Ausgangssignals der Frequenz des Eingangssignals.

Gemäß der Schaltung berechnet sich die Ladezeit $t_2$ von dem Kondensator $C_2$ zu:

$$(3) \qquad t_2 = C_2 \times U_{ref} / I_2.$$

Daraus ergibt sich das Tastverhältnis des Ausgangssignals CLK_OUT zu:

$$(4) \qquad D = t_2 / T = t_2 / (2 \times t_1) = (C_2 * I_1) / (2 \times C_1 \times I_2).$$

Die Ströme $I_1$ und $I_2$ und die Kapazitäten $C_1$ und $C_2$ können frei gewählt werden. Das Tastverhältnis D kann zwischen 0 % und 100 % eingestellt werden.

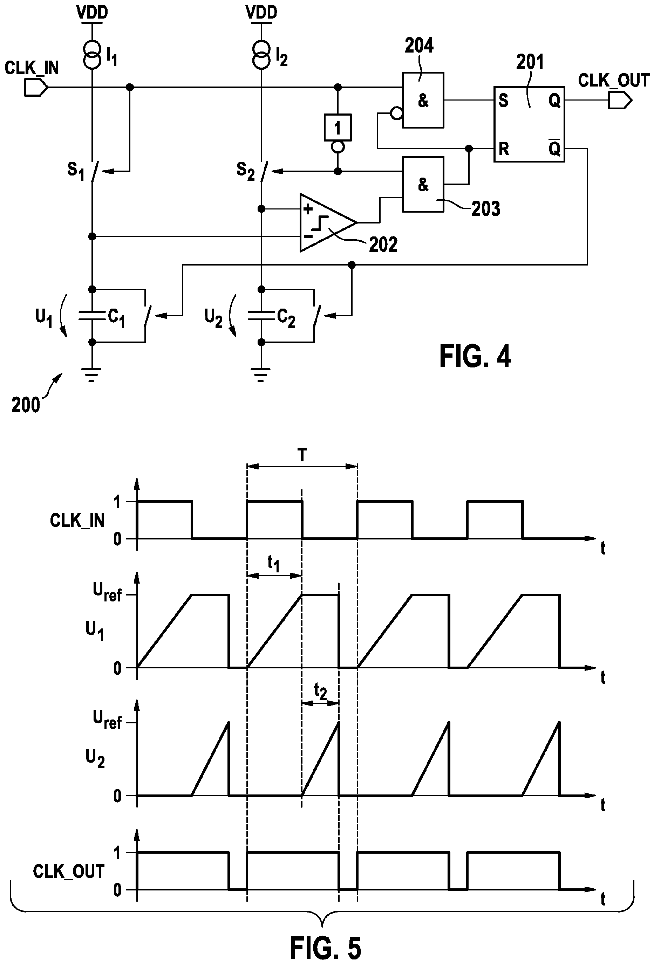

In Figur 4 ist eine erfindungsgemäße vereinfachte Schaltung 200 dargestellt, mit der ein beliebiges

Tastverhältnis zwischen 50 % und 100 % eingestellt werden kann. Im Vergleich zu Figur 1 entfallen die Abtast-Halte-Schaltung und die Generierung der drei nicht überlappenden Taktsignale $S_1$, $S_2$ und $S_3$. Die dazugehörigen Signalverläufe der Schaltung 200 sind in Figur 5 dargestellt.

Während CLK_IN = 1 wird der Kondensator $C_1$ von der Stromquelle $I_1$ auf die Spannung $U_{ref}$ aufgeladen, was im Spannungsverlauf $U_1$ in Figur 5 dargestellt ist. Die Spannung $U_{ref}$ berechnet sich zu:

$$(5) \qquad U_{ref} = I_1 / (t_1 \times C_1).$$

Die Ladezeit $t_1$ entspricht der halben Periodendauer T des Eingangssignals CLK_IN:

$$(6) \qquad t_1 = C_1 \times U_{ref} / I_1 = T / 2.$$

Mit jeder steigenden Flanke von CLK_IN wird ein SR-Flipflop 201 gesetzt, was dazu führt, dass das Ausgangssignal CLK_OUT auf 1 steigt.

Wenn das Eingangssignal CLK_IN = 0 ist, wird der zweite Kondensator $C_2$ über einen Schalter $S_2$ geladen, bis dessen Spannung $U_2$ den Wert $U_{ref}$ erreicht. Während des Ladevorgangs des zweiten Kondensators $C_2$ verändert sich der Zustand des SR-Flipflops 201 nicht, sodass an dem Signal CLK_OUT weiterhin eine 1 anliegt.

Ein Komparator 202 vergleicht die beiden Spannungen $U_1$ und $U_2$ miteinander und gibt ein Ausgangssignal aus, wenn die Spannung $U_2$ über dem Kondensator $C_2$ den Wert $U_{ref}$ des geladenen ersten Kondensators $C_1$ erreicht. Ein UND-Gatter 203 verknüpft den Ausgang des Komparators 202 mit dem negierten Eingangssignal CLK_IN, sodass nun das SR-Flipflop 201 zurückgesetzt wird. Mit dem vom Komparator 202 ausgelösten Zurücksetzen des SR-Flipflops 201 wird der Impuls des Ausgangssignals CLK_OUT beendet. Über den invertierenden Ausgang des SR-Flipflops 201, der nun aktiv ist, werden über Schalter die beiden Kondensatoren $C_1$ und $C_2$ entladen. Ein UND-Gatter 204 verknüpft das Eingangssignal CLK_IN mit dem invertierten Signal des UND-Gatters 203, um den Ausgang an dem Eingang des SR-Flipflops 201 zur Verfügung zu stellen.

Die Ladezeit $t_2$ von $C_2$ berechnet sich zu:

$$(7) \qquad t_2 = C_2 \times U_{ref} / I_2.$$

Daraus ergibt sich das Tastverhältnis von CLK_OUT zu:

$$(8) \qquad D = (t_1 + t_2) / T = \tfrac{1}{2} \times (1 + t_2 / t_1) = \tfrac{1}{2} \times [1 + (C_2 \times I_1) / (C_1 \times I_2)].$$

Die Ströme $I_1$ und $I_2$ und die Kapazitäten $C_1$ und $C_2$ können frei gewählt werden. Das Tastverhältnis kann zwischen 50 % und 100 % eingestellt werden. Hier entspricht die Impulsdauer des Ausgangssignals CLK_OUT der Ladezeitdauer $t_1$ des ersten Kondensators $C_1$ plus der Ladezeitdauer $t_2$ des zweiten Kondensators $C_2$. Oder anders ausgedrückt, entspricht der Impuls des Ausgangssignals CLK_OUT dem Impuls des Eingangssignals CLK_IN plus der Ladezeitdauer $t_2$ des zweiten Kondensators $C_2$. Hier wird der erste Kondensator $C_1$ während der Impulsdauer des Eingangssignals CLK_IN aufgeladen, während der zweite Kondensator $C_2$ während des Nullanteils des Eingangssignals CLK_IN geladen wird. Die beiden Ladezeitdauern $t_1$ und $t_2$ werden zu dem Tastverhältnis zwischen 50% und 100% addiert.

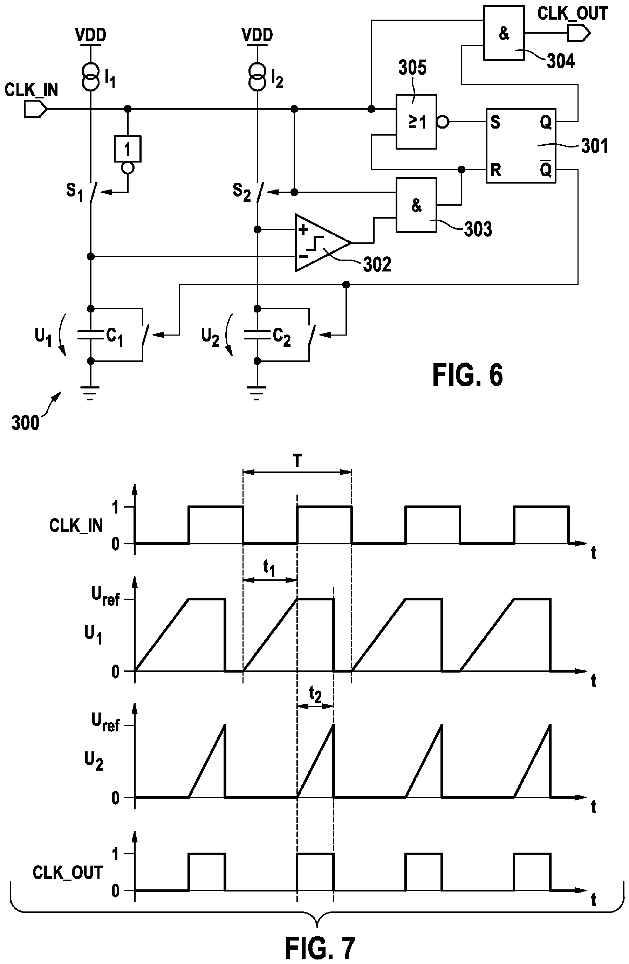

In Figur 6 ist eine Schaltung 300 zum Erzeugen eines beliebigen Tastverhältnisses zwischen 0 und 50 % dargestellt. Die Schaltung 300 ist wiederum eine vereinfachte Schaltung aus Figur 1. So entfallen auch hier die Abtast-Halte-Schaltung und die Generierung der drei nicht überlappenden Taktsignale $S_1$, $S_2$ und $S_3$.

Die Schaltung 300 weist wiederum einen ersten Kondensator $C_1$, welcher über einen ersten Schalter $S_1$ mit einer ersten Stromquelle $I_1$ verbunden ist, auf. Entsprechend ist ein zweiter Kondensator $C_2$ über einen zweiten Schalter $S_2$ mit einer zweiten Stromquelle $I_2$ verbunden. Mit jeder fallenden Flanke des Eingangssignals CLK_IN wird ein SR-Flipflop 301 gesetzt. Während CLK_IN = 0 wird die Kapazität oder der Kondensator $C_1$ von der Stromquelle $I_1$ auf die Spannung $U_{ref}$ aufgeladen, dies ist im Spannungsverlauf $U_1$ in Figur 7 dargestellt. Die Spannung $U_{ref}$ berechnet sich zu:

$$(9) \qquad U_{ref} = I_1 / (t_1 \times C_1).$$

Die Ladezeit $t_1$ entspricht der halben Periodendauer T des Grundtaktes oder Eingangssignals CLK_IN:

$$(10) \qquad t_1 = C_1 \times U_{ref} / I_1 = T / 2.$$

Mit der steigenden Flanke von CLK_IN wird die Kapazität $C_2$ von der Stromquelle $I_2$ geladen. Detektiert ein Komparator 302, welcher die beiden Spannungen $U_1$ und $U_2$ miteinander vergleicht, dass die Spannung $U_2$ über dem zweiten Kondensator $C_2$ gleich der Ladespannung $U_{ref}$ des ersten Kondensators $C_1$ ist, so wird ein Ausgangssignal des Komparators 302 gesetzt. Ein UND-Gatter 303, dessen Eingänge mit dem Ausgang des Komparators 302 und dem Eingangssignal CLK_IN geschaltet sind, gibt nun ein Ausgangssignal aus und setzt damit das SR-Flipflop 301 zurück, was den Ausgang des SR-Flipflops 301 auf 0 setzt und den invertierten Ausgang auf 1. Dies führt dazu, dass über zwei Schalter die beiden Kondensatoren $C_1$ und $C_2$ entladen werden. Ein NOR-Gatter 305 verknüpft das Eingangssignal CLK_IN mit dem Ausgangssignal des UND-Gatters 303, um den Ausgang an dem Eingang des SR-Flipflops 301 zur Verfügung zu stellen.

Die Eingänge eines UND-Gatters 304 sind mit dem Eingangssignal CLK_IN und mit dem Ausgang Q des SR-Flipflops 301 verbunden. An dem Ausgang des UND-Gatters 304 liegt das Ausgangssignal CLK_OUT an. Dies bedeutet für das Ausgangssignal CLK_OUT, dass mit steigender Flanke des Eingangssignals CLK_IN auch die Flanke des Ausgangssignals CLK_OUT steigt, da mit der zuvor fallenden Flanke des Eingangssignals CLK_IN das SR-Flipflop 301 gesetzt wurde. Durch das von dem Komparator 302 eingeleitete Zurücksetzen des SR-Flipflops 301 wird das UND-Gatter 304 gesperrt, sodass der Impuls des Ausgangssignals CLK_OUT beendet wird. Die Zeitdauer des Impulses des Ausgangssignals von CLK_OUT entspricht daher der Ladezeitdauer $t_2$ des zweiten Kondensators $C_2$.

Die Ladezeit $t_2$ des zweiten Kondensators $C_2$ berechnet sich zu:

$$(11) \qquad t_2 = C_2 \times U_{ref} / I_2.$$

Das Taktsignal CLK_OUT ergibt sich zu:

$$(12) \qquad D = t_2 / T = t_2 / (2 \times t_1) = (C_2 \times I_1) / (2 \times C_1 \times I_2).$$

Die Ströme $I_1$ und $I_2$ und die Kapazitäten $C_1$ und $C_2$ können frei gewählt werden. Das Tastverhältnis D kann zwischen 0 % und 50 % eingestellt werden. Hier wird der erste Kondensator $C_1$ während des Nullanteils des Eingangssignals CLK_IN aufgeladen, während der zweite Kondensator $C_2$ während der Impulsdauer des Eingangssignals CLK_IN geladen wird. Das Ausgangssignal CLK_OUT entspricht dem Eingangssignal CLK_IN, solange der zweite Kondensator $C_2$ geladen wird. In anderen Worten wird das Tastverhältnis zwischen 0% und 50% durch die Ladezeitdauer $t_2$ bestimmt.

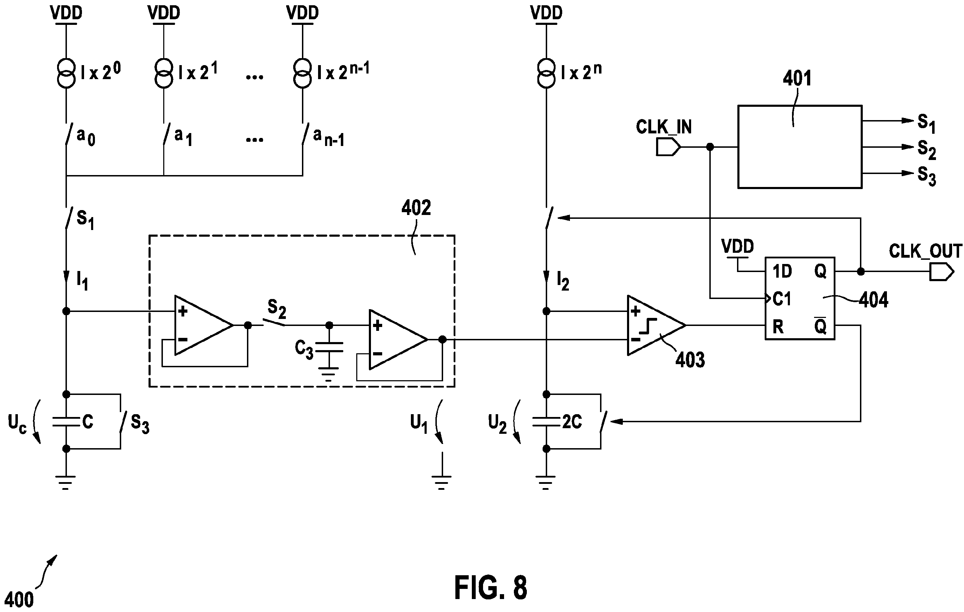

In Figur 8 ist eine weitere Schaltung 400 dargestellt, mit der ein Ausgangssignal CLK_OUT mit einem variablen oder einstellbaren Tastverhältnis zwischen 0 und 100 % erzeugt werden kann. Die Schaltung 400 basiert im Wesentlichen auf der Schaltung 100 aus Figur 1. Die Schaltung 400 weist wie die Schaltung 100 eine Schalteransteuerung 401, eine Abtast-Halte-Schaltung 402, einen Komparator 403 sowie ein D-Flipflop 404 auf. Der Kondensator $C_1$ mit einer Kapazität von C ist über einen Schalter $S_1$ mit mehreren Stromquellen $I \times 2^0$ bis $I \times 2^{n-1}$ verbunden. Jede der Stromquellen ist über einen Schalter $a_0$ bis $a_{n-1}$ angebunden, sodass mit einem Datenwort $[a_{n-1} \dots a_0]$ der Strom $I_1$ über die schaltbaren Stromquellen $I \times 2^0$ bis $I \times 2^{n-1}$ eingestellt werden kann:

$$(13) \qquad I_1 = (a_0 \times 2^0 + \dots + a_{n-1} \times 2^{n-1}) \times I.$$

Der Strom I ist beliebig wählbar. Der Strom $I_2$ aus der Stromquelle $I \times 2^n$ wird auf den Wert

$$(14) \qquad I_2 = 2^n \times I$$

eingestellt.

Die zweite Kapazität, über welche die Spannung $U_2$ abfällt, wird gewählt als $2 \times C_1$, also in diesem Fall 2C.

Dies kann dargestellt werden als:

$$(15) \qquad C_2 = 2 \text{ x } C_1 = 2 \text{ x } C.$$

Daraus ergibt sich das Tastverhältnis D von CLK_OUT entsprechend (Formel 4) von Figur 1 zu:

$$(16) \qquad D = (a_0 \text{ x } 2^0 + \ldots + a_{n-1} \text{ x } 2^{n-1}) \text{ / } 2^n.$$

Es lassen sich so Tastverhältnisse von

$$(17) \qquad D = [0 \text{ ; } (2^n - 1) \text{ / } 2^n]$$

einstellen. Die in Figur 3 dargestellten Signalverläufe für die Schaltung 100 gelten entsprechend für die Schaltung 400. Ebenso entspricht die Funktionsweise der Schaltung 100 jener der Schaltung 400.

Alternativ können die beiden Ströme $I_1$ und $I_2$ durch Division mit einem Faktor, vorzugsweise $(a_0 \text{ x } 2^0 + \ldots + a_{n-1} \text{ x } 2^{n-1})$, normiert werden. Dadurch ergibt sich der Strom $I_1$ gemäß Gleichung (13) zu $I_1 = I$ und der Strom $I_2$ gemäß Gleichung (14) zu $I_2 = [2^n \text{ / } (a_0 \text{ x } 2^0 + \ldots + a_{n-1} \text{ x } 2^{n-1})] \text{ x } I$. Da $U_{ref}$ von $U_1$ bestimmt wird und $I_1$ hier konstant gehalten wird, hat $U_{ref}$ immer den gleichen Wert bei gleicher Frequenz des Eingangssignals. Der Komparator 403 schaltet daher unabhängig von dem eingestellten Datenwort immer bei der gleichen Schwelle. Allerdings ändert sich damit die Anstiegsgeschwindigkeit der Spannung $U_2$ über dem Kondensator $C_2$ mit dem Datenwort. Beide Realisierungen können miteinander kombiniert werden. Beispielsweise kann die Division nur durch die höherwertigen Terme erfolgen.

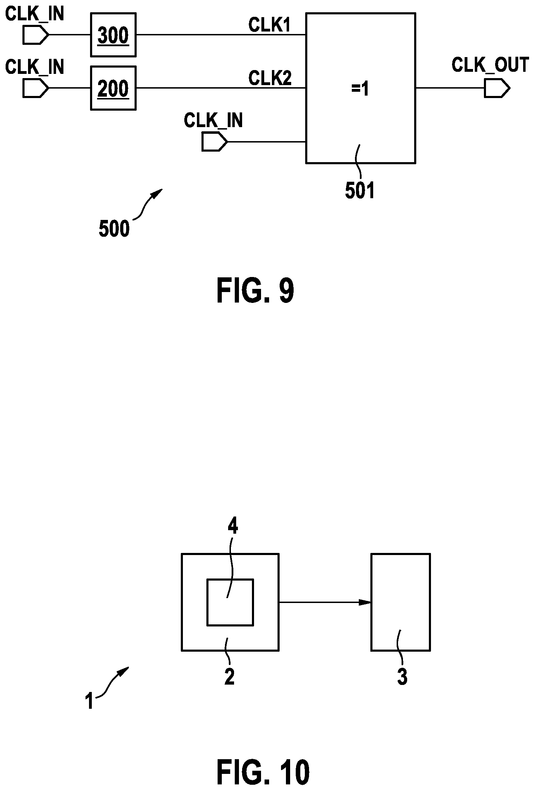

In Figur 9 ist eine Schaltung 500 dargestellt, mit welcher eine Frequenzverdopplung eines Eingangssignals CLK_IN erzielt werden kann.

Dazu wird von der in Figur 6 dargestellten Schaltung 300 aus dem Eingangssignal CLK_IN ein Ausgangssignal oder Zwischensignal CLK1 mit einem Tastverhältnis von 25 % erzeugt. Von der in Figur 4 dargestellten Schaltung 200 wird aus dem Eingangssignal CLK_IN ein Signal CLK2, wie ein Ausgangssignal oder Zwischensignal, mit einem Tastverhältnis von 75 % generiert.

Die beiden Ausgangssignale CLK1 und CLK2 der beiden Schaltungen 300 und 200 sowie das Eingangssignal CLK_IN mit einem Tastverhältnis von 50 % werden einem XOR-Gatter 501 zugeführt, an dessen Ausgang dann das Ausgangssignal CLK_OUT mit doppelter Frequenz im Vergleich zu dem Eingangssignal CLK_IN beziehungsweise den beiden Signalen CLK1 und CLK2 ausgegeben wird.

Entsprechend berechnet sich das Ausgangssignal zu:

$$(18) \qquad CLK\_OUT = CLK\_IN \text{ xor } CLK1 \text{ xor } CLK2.$$

In Figur 10 ist eine schematische Darstellung eines digitalen Schaltreglers 1 gezeigt. Der digitale Schaltregler 1 weist einen Digitalteil 2 zum Erzeugen eines Ansteuerungssignals mit einem Tastverhältnis auf sowie eine Endstufe 3, die mit diesem Signal angesteuert wird. Der Digitalteil 2 enthält eine Schaltung 4, die eine der Schaltungen 100, 200, 300, 400 oder 500 entspricht. Das Ansteuerungssignal kann dann dem Ausgangssignal CLK_OUT entsprechen. Weitere Komponenten des digitalen Schaltreglers, wie die Erfassung der Regelspannung und eventuell der Eingangsspannung, werden hier aus Gründen der Übersichtlichkeit nicht betrachtet.

Die zuvor beschriebenen Schaltungen können überall dort eingesetzt werden, wo ein Takt mit einem festen oder einstellbaren Tastverhältnis benötigt wird und dieses Ausgangssignal nicht durch eine digitale Schaltung aus einem schnelleren Grundtakt erzeugt werden kann oder soll. So können beispielsweise PWM (pulsweitenmodulierte) Signale zur Ansteuerung von Motoren oder Lampen vorzugsweise im Kraftfahrzeugbereich verwendet werden.

**Patentansprüche**

1. Schaltung zur Erzeugung eines Ausgangssignals (CLK_OUT) mit einem zweiten Tastverhältnis aus einem Eingangssignal (CLK_IN) mit einem ersten Tastverhältnis, wobei
die Schaltung (100; 200; 300; 400; 500) einen ersten Kondensator ($C_1$) und einen zweiten Kondensator ($C_2$) aufweist, die jeweils mit einer Ladungsquelle ($I_1$, $I_2$; $I \text{x} 2^0$, ..., $I \text{x} 2^{n-1}$, $I \text{x} 2^n$) zum periodischen Laden der Kondensatoren ($C_1$,

$C_2$) verbunden sind, wobei der erste Kondensator ($C_1$) über einen von dem Eingangssignal (CKL_IN) gesteuerten ersten Schalter (S1) und der zweite Kondensator ($C_2$) über einen von dem invertierten Eingangssignal gesteuerten zweiten Schalter (S2) geladen wird, und wobei eine Spannung über den geladenen ersten Kondensator ($C_1$) als Referenzspannung ($U_{ref}$) definiert ist und wobei das Tastverhältnis des Ausgangssignals (CLK_OUT) von der Ladezeitdauer ($t_2$) des zweiten Kondensators ($C_2$) bis zum Erreichen der Referenzspannung ($U_{ref}$) definiert ist, wobei ein Komparator (110; 202; 302; 403) zum Vergleich der Referenzspannung ($U_{ref}$) und der Spannung des zweiten Kondensators ($C_2$) vorgesehen ist und wobei ein bistabiles Kippglied (109; 201; 301; 404) vorgesehen ist, dessen Eingänge mit einem Ausgang des Komparators (110; 202; 302; 403) und mit dem Eingangssignal (CLK_IN) in Kommunikation stehen und mit dessen Ausgang das Ausgangssignal (CLK_OUT) zur Verfügung gestellt ist, sodass die Impulsdauer des Ausgangssignals (CKL_OUT) der Ladezeitdauer ($t_1$) des ersten Kondensators ($C_1$) plus der Ladezeitdauer ($t_2$) des zweiten Kondensators ($C_2$) entspricht.

2. Schaltung nach Anspruch 1, wobei das Eingangssignal (CLK_IN) und das Ausgangssignal (CLK_OUT) eine identische Frequenz aufweisen.

3. Schaltung nach einem der Ansprüche 1 bis 2, wobei an einem Signaleingang des bistabilen Kippglieds (201) der Impulsanteil des Eingangssignals (CLK_IN) und an einem Reset-Eingang des bistabilen Kippglieds (201) das Ausgangssignal des Komparators (203) derart anliegen, dass das Tastverhältnis des Ausgangssignals (CLK_OUT) zwischen 50% und 100% beträgt.

4. Verfahren zur Erzeugung eines Ausgangssignals (CLK_OUT) mit einem zweiten Tastverhältnis aus einem Eingangssignal (CLK_IN) mit einem ersten Tastverhältnis, wobei ein erster Kondensator ($C_1$) periodisch von einer Ladungsquelle ($I_1$; $Ix2^0$, ..., $Ix2^{n-1}$) bis zu einer Referenzspannung ($U_{ref}$) aufgeladen wird, dass ein zweiter Kondensator ($C_2$) periodisch von einer weiteren Ladungsquelle ($I_2$, $Ix2^n$) aufgeladen wird, wobei der erste Kondensator ($C_1$) über einen von dem Eingangssignal (CKL_IN) gesteuerten ersten Schalter (S1) und der zweite Kondensator ($C_2$) über einen von dem invertierten Eingangssignal gesteuerten zweiten Schalter (S2) geladen wird, und wobei das Tastverhältnis des Ausgangssignals (CLK_OUT) aus der bis zum Erreichen der Referenzspannung ($U_{ref}$) benötigten Ladezeitdauer ($t_2$) des zweiten Kondensators ($C_2$) gebildet wird, wobei ein Komparator (110; 202; 302; 403) die Referenzspannung ($U_{ref}$) und die Spannung des zweiten Kondensators ($C_2$) vergleicht und wobei ein bistabiles Kippglied (109; 201; 301; 404) vorgesehen ist, dessen Eingänge mit einem Ausgang des Komparators (110; 202; 302; 403) und mit dem Eingangssignal (CLK_IN) in Kommunikation stehen und mit dessen Ausgang das Ausgangssignal (CLK_OUT) zur Verfügung gestellt wird, sodass die Impulsdauer des Ausgangssignals (CKL_OUT) der Ladezeitdauer ($t_1$) des ersten Kondensators ($C_1$) plus der Ladezeitdauer ($t_2$) des zweiten Kondensators ($C_2$) entspricht.

5. Verfahren nach Anspruch 4, wobei parallel zwei Ausgangssignale (CLK1, CLK2) erzeugt werden, wobei die zwei Ausgangssignale (CLK1, CLK2) zu einem Tastverhältnis von 50% komplementäre Tastverhältnisse aufweisen, und wobei die beiden Ausgangssignale (CLK1, CLK2) und das Eingangssignal (CLK_IN) zur Erzeugung des Ausgangssignals (CLK_OUT) XOR-verknüpft werden.

6. Digitaler Schaltregler mit einem Digitalteil (2) zum Erzeugen eines Ansteuerungssignals mit einem Tastverhältnis, einer mit dem Ansteuerungssignal angesteuerten Endstufe (3), **gekennzeichnet durch** eine Schaltung (100; 200; 300; 400; 500) zur Erzeugung des Ansteuerungssignals nach einem der Ansprüche 1 bis 3.

7. Kraftfahrzeug mit einer Schaltung nach einem der Ansprüche 1 bis 3 oder mit einem digitalen Schaltregler nach Anspruch 6, **dadurch gekennzeichnet, dass** die Schaltung (100; 200; 300; 400; 500) oder der Schaltregler (1) mit einem Bordnetz des Kraftfahrzeugs in Verbindung steht.

**Claims**

1. Circuit for generating an output signal (CLK_OUT) having a second duty ratio from an input signal (CLK_IN) having a first duty ratio, wherein
the circuit (100; 200; 300; 400; 500) has a first capacitor ($C_1$) and a second capacitor ($C_2$), which are each connected to a charge source ($I_1$, $I_2$; $Ix2^0$, ..., $Ix2^{n-1}$, $Ix2^n$) for periodically charging the capacitors ($C_1$, $C_2$), wherein the first capacitor ($C_1$) is charged via a first switch (S1) controlled by the input signal (CKL_IN) and the second capacitor ($C_2$) is charged via a second switch (S2) controlled by the inverted input signal, and wherein a voltage across the charged first capacitor ($C_1$) is defined as reference voltage ($U_{ref}$) and wherein
the duty ratio of the output signal (CLK_OUT) is defined by the charging period ($t_2$) of the second capacitor ($C_2$)

before the reference voltage ($U_{ref}$) is reached, wherein there is provision for a comparator (110; 202; 302; 403) for comparing the reference voltage ($U_{ref}$) and the voltage of the second capacitor ($C_2$) and wherein there is provision for a bistable multivibrator (109; 201; 301; 404), the inputs of which are able to communicate with an output of the comparator (110; 202; 302; 403) and with the input signal (CLK_IN) and the output of which provides the output signal (CLK_OUT), so that the pulse duration of the output signal (CKL_OUT) corresponds to the charging period ($t_1$) of the first capacitor ($C_1$) plus the charging period ($t_2$) of the second capacitor ($C_2$).

2. Circuit according to Claim 1, wherein the input signal (CLK_IN) and the output signal (CLK_OUT) have an identical frequency.

3. Circuit according to either of Claims 1 and 2, wherein a signal input of the bistable multivibrator (201) has the pulse component of the input signal (CLK_IN) applied to it and a reset input of the bistable multivibrator (201) has the output signal of the comparator (203) applied to it such that the duty ratio of the output signal (CLK_OUT) is between 50% and 100%.

4. Method for generating an output signal (CLK_OUT) having a second duty ratio from an input signal (CLK_IN) having a first duty ratio, wherein a first capacitor ($C_1$) is periodically charged to a reference voltage ($U_{ref}$) by a charge source ($I_1$; $Ix2^0$, ..., $Ix2^{n-1}$), that a second capacitor ($C_2$) is periodically charged by a further charge source ($I_2$, $Ix2^n$), wherein the first capacitor ($C_1$) is charged via a first switch (S1) controlled by the input signal (CKL_IN) and the second capacitor ($C_2$) is charged via a second switch (S2) controlled by the inverted input signal, and wherein the duty ratio of the output signal (CLK_OUT) is formed from the charging period ($t_2$) needed for the second capacitor ($C_2$) before the reference voltage ($U_{ref}$) is reached, wherein a comparator (110; 202; 302; 403) compares the reference voltage ($U_{ref}$) and the voltage of the second capacitor ($C_2$) and wherein there is provision for a bistable multivibrator (109; 201; 301; 404), the inputs of which are able to communicate with an output of the comparator (110; 202; 302; 403) and with the input signal (CLK_IN) and the output of which provides the output signal (CLK_OUT), so that the pulse duration of the output signal (CKL_OUT) corresponds to the charging period ($t_1$) of the first capacitor ($C_1$) plus the charging period ($t_2$) of the second capacitor ($C_2$).

5. Method according to Claim 4, wherein two output signals (CLK1, CLK2) are generated in parallel, wherein the two output signals (CLK1, CLK2) have duty ratios complementary to a duty ratio of 50%, and wherein the two output signals (CLK1, CLK2) and the input signal (CLK_IN) are XORed to generate the output signal (CLK_OUT).

6. Digital switched-mode regulator having a digital part (2) for generating an actuation signal having a duty ratio, and an output stage (3) actuated using the actuation signal, **characterized by** a circuit (100; 200; 300; 400; 500) for generating the actuation signal according to one of Claims 1 to 3.

7. Motor vehicle having a circuit according to one of Claims 1 to 3 or having a digital switched-mode regulator according to Claim 6, **characterized in that** the circuit (100; 200; 300; 400; 500) or the switched-mode regulator (1) is connected to a vehicle electrical system of the motor vehicle.

**Revendications**

1. Circuit, destiné à générer un signal de sortie (CLK_OUT) ayant un deuxième rapport cyclique à partir d'un signal d'entrée (CLK_IN) ayant un premier rapport cyclique,
le circuit (100 ; 200 ; 300 ; 400 ; 500) comportant un premier condensateur ($C_1$) et un deuxième condensateur ($C_2$) qui sont reliés chacun avec une source de charge ($I_1$, $I_2$ ; $Ix2^0$, ..., $Ix2^{n-1}$, $Ix2^n$) pour la charge périodique des condensateurs ($C_1$, $C_2$), le premier condensateur ($C_1$) étant chargé par l'intermédiaire d'un premier commutateur (S1) commandé par le signal d'entrée (CKL_IN) et le deuxième condensateur ($C_2$) étant chargé par l'intermédiaire d'un deuxième commutateur (S2) commandé par le signal d'entrée inversé et une tension sur le premier condensateur ($C_1$) chargé étant définie comme tension de référence ($U_{ref}$) et le rapport cyclique du signal de sortie (CLK_OUT) étant défini par la durée de charge ($t_2$) du deuxième condensateur ($C_2$) jusqu'à l'atteinte de la tension de référence ($U_{ref}$), un comparateur (110 ; 202 ; 302 ; 403) étant prévu pour comparer la tension de référence ($U_{ref}$) et la tension du deuxième condensateur ($C_2$) et un élément à bascule (109 ; 201 ; 301 ; 404) bistable étant prévu, dont les entrées sont en communication avec une sortie du comparateur (110 ; 202 ; 302 ; 403) et avec le signal d'entrée (CLK_IN) et par la sortie duquel le signal de sortie (CLK_OUT) est mis à disposition, de telle sorte que la durée d'impulsion du signal de sortie (CKL_OUT) corresponde à la durée de charge ($t_1$) du premier condensateur ($C_1$) plus la durée de charge ($t_2$) du deuxième condensateur ($C_2$).

**2.** Circuit selon la revendication 1, le signal d'entrée (CLK_IN) et le signal de sortie (CLK_OUT) présentant une fréquence identique.

**3.** Circuit selon l'une quelconque des revendications 1 et 2, la composante d'impulsion du signal d'entrée (CLK_IN) étant appliquée sur une entrée de signal de l'élément à bascule (201) bistable et le signal de sortie du comparateur (203) étant appliqué sur une entrée de réinitialisation de l'élément à bascule (201) bistable, de telle sorte que le rapport cyclique du signal de sortie (CLK_OUT) est compris entre 50% et 100%.

**4.** Procédé, destiné à générer un signal de sortie (CLK_OUT) ayant un deuxième rapport cyclique à partir d'un signal d'entrée (CLK_IN) ayant un premier rapport cyclique, un premier condensateur ($C_1$) étant chargé périodiquement par une source de charge ($I_1$ ; $I \times 2^0$, ..., $I \times 2^{n-1}$) jusqu'à une tension de référence ($U_{ref}$), en ce qu'un deuxième condensateur ($C_2$) est chargé périodiquement par une autre source de charge ($I_2$, $I \times 2^n$), le premier condensateur ($C_1$) étant chargé par l'intermédiaire d'un premier commutateur (S1) commandé par le signal d'entrée (CKL_IN) et le deuxième condensateur ($C_2$) étant chargé par l'intermédiaire d'un deuxième commutateur (S2) commandé par le signal d'entrée inversé, et le rapport cyclique du signal de sortie (CLK_OUT) étant constitué de la durée de charge ($t_2$) du deuxième condensateur ($C_2$) nécessaire jusqu'à l'atteinte de la tension de référence ($U_{ref}$), un comparateur (110 ; 202 ; 302 ; 403) comparant la tension de référence ($U_{ref}$) et la tension du deuxième condensateur ($C_2$) et un élément à bascule (109 ; 201 ; 301 ; 404) étant prévu, dont les entrées sont en communication avec une sortie du comparateur (110 ; 202 ; 302 ; 403) et avec le signal d'entrée (CLK_IN) et par la sortie duquel le signal de sortie (CLK_OUT) est mis à disposition, de telle sorte que la durée d'impulsion du signal de sortie (CKL_OUT) corresponde à la durée de charge ($t_1$) du premier condensateur ($C_1$) plus la durée de charge ($t_2$) du deuxième condensateur ($C_2$).

**5.** Procédé selon la revendication 4, deux signaux de sortie (CLK1, CLK2) étant générés en parallèle, les deux signaux de sortie (CLK1, CLK2) présentant des rapports cycliques complémentaires à un rapport cyclique de 50 % et les deux signaux de sortie (CLK1, CLK2) ainsi que le signal d'entrée (CLK_IN) étant interconnectés OU exclusif, pour générer le signal de sortie (CLK_OUT).

**6.** Régulateur de commutation numérique, comprenant une partie numérique (2) destinée à générer un signal d'activation ayant un rapport cyclique, un amplificateur de puissance (3), activé par le signal d'activation, **caractérisé par** un circuit (100 ; 200 ; 300 ; 400 ; 500) destiné à générer le signal d'activation selon l'une quelconque des revendications 1 à 3.

**7.** Véhicule automobile, pourvu d'un circuit selon l'une quelconque des revendications 1 à 3 ou d'un régulateur de commutation numérique selon la revendication 6, **caractérisé en ce que** le circuit (100 ; 200 ; 300 ; 400 ; 500) ou le régulateur de commutation (1) est connecté à un réseau de bord du véhicule automobile.

**FIG. 1**

EP 3 039 786 B1

FIG. 2

FIG. 3

FIG. 4

FIG. 5

**FIG. 6**

**FIG. 7**

FIG. 8

CLK_IN

300

CLK1

CLK_IN

200

CLK2

=1

CLK_OUT

CLK_IN

501

500

## FIG. 9

4

2

3

1

## FIG. 10

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 6154076 A
- US 3883756 A
- EP 0135121 A1
- US 5451893 A